# FASCICULE DE BREVET EUROPEEN

(11) **EP 4 437 589 B1**
(45) Date de publication et mention de la délivrance du brevet: **22.10.2025**
(21) Numéro de dépôt: 22813318.7
(22) Date de dépôt: 08.11.2022
(51) Int. Cl.: H10H 29/34, H10H 29/855

(54) **PIXEL D'AFFICHAGE À DIODES ÉLECTROLUMINESCENTES POUR ÉCRAN D'AFFICHAGE**
LEUCHTDIODENANZEIGEPIXEL FÜR EINEN ANZEIGEBILDSCHIRM
LIGHT-EMITTING-DIODE DISPLAY PIXEL FOR A DISPLAY SCREEN

(30) Priorité: 26.11.2021 FR 2112579; 26.11.2021 FR 2112580
(43) Date de publication de la demande: 02.10.2024
(73) Titulaire: Aledia, 38800 Champagnier (FR)
(72) Inventeur: JEANNIN, Olivier, 38000 GRENOBLE (FR); ROBIN, Ivan Christophe, 38000 GRENOBLE (FR); MERCIER, Frédéric, 38500 COUBLEVIE (FR)
(74) Mandataire: Cabinet Beaumont
(86) Numéro de dépôt international: PCT/EP2022/081143
(87) Numéro de publication internationale: WO 2023/094142

(56) Documents cités:
- EP-A1- 3 690 944
- WO-A1-2019/236325
- CN-A- 112 349 707

## Description

La présente demande de brevet revendique la priorité de la demande de brevet français FR21/12579 et de la demande de brevet français FR21/12580.

### Domaine technique

La présente description concerne de façon générale des pixels d'affichage comprenant des diodes électroluminescentes pour écran d'affichage.

### Technique antérieure

Un pixel d'une image correspond à l'élément unitaire de l'image affichée par un écran d'affichage. Pour l'affichage d'images couleur, un écran d'affichage comprend en général pour l'affichage de chaque pixel de l'image au moins trois composants, également appelés sous-pixels d'affichage, qui émettent chacun un rayonnement lumineux sensiblement dans une seule couleur (par exemple, le rouge, le vert et le bleu). La superposition des rayonnements émis par ces trois sous-pixels d'affichage fournit à l'observateur la sensation colorée correspondant au pixel de l'image affichée. Dans ce cas, on appelle pixel d'affichage de l'écran d'affichage l'ensemble formé par les trois sous-pixels d'affichage utilisés pour l'affichage d'un pixel d'une image. Chaque sous-pixel d'affichage peut comprendre une source lumineuse, notamment une diode électroluminescente.

Les pixels d'affichage peuvent être répartis de façon matricielle, chaque pixel d'affichage étant situé à l'intersection d'une rangée (ou ligne) et d'une colonne de la matrice. En général, chaque rangée de pixels d'affichage est sélectionnée successivement, et les pixels d'affichage de la rangée sélectionnée sont programmés pour afficher les pixels d'image souhaités.

Une matrice active est une architecture de pilotage d'écran permettant de maintenir toutes les lignes de pixels actives pendant toute la durée d'une image contrairement aux matrices dites passives où chaque ligne n'est active que pendant un temps T=Tframe/N (où Tframe est la durée de l'image et N le nombre de lignes de l'écran). Ceci permet d'optimiser le fonctionnement des diodes électroluminescentes. En outre, il est possible d'envoyer de faibles niveaux de tension ou de courant sur les lignes de commande de la matrice, ce qui permet d'afficher des flux de données plus importants.

Dans le cadre d'écran à base de diodes électroluminescentes de dimensions micrométriques, la taille des diodes électroluminescentes est généralement inférieure à la surface disponible sur l'écran pour le pixel de l'image grâce à la forte luminosité intrinsèque des diodes électroluminescentes. Un procédé de fabrication d'un écran d'affichage consiste à déposer ces diodes électroluminescentes unitaires sur un support, également appelé dalle, contenant l'électronique de pilotage. Un autre procédé de fabrication consiste à utiliser des pixels d'affichage comprenant des diodes électroluminescentes et un circuit de commande des diodes électroluminescentes. On parle alors de pixels intelligents. Ceci permet notamment de simplifier la réalisation d'une matrice active, puisque l'électronique de commande des diodes électroluminescentes du pixel d'affichage est pour l'essentiel embarquée sur le pixel d'affichage. Le document WO 2018/185433 décrit un exemple de pixel intelligent.

La tendance est à l'augmentation du nombre de pixels d'affichage de l'écran. Ceci entraîne une augmentation du coût et de la durée de la fabrication de l'écran d'affichage qui dépend notamment du nombre d'opérations de mise en place des pixels d'affichage sur la dalle, ce qui n'est pas souhaitable.

Il est souhaitable que les dimensions des pixels d'affichage soient les plus faibles possibles pour réduire la quantité de matériaux semiconducteurs composant les pixels d'affichage et donc réduire les coûts de fabrication de ces pixels d'affichage. Toutefois, la fixation de pixels d'affichage de petites dimensions à la dalle peut alors être difficile, en particulier pour assurer une connexion électrique convenable entre des plots conducteurs des pixels d'affichage et des pistes conductrices de la dalle. Ce problème est d'autant plus sensible au vu de la tendance actuelle à l'augmentation du nombre de pixels d'affichage de l'écran.

CN 112 349 707 A, EP 3 690 944 A1 et WO 2019/236325 A1 divulguent des blocs d'affichage selon l'art antérieur.

### Résumé de l'invention

Un objet d'un mode de réalisation est de prévoir un des pixel d'affichage comprenant des diodes électroluminescentes pour un écran d'affichage palliant tout ou partie des inconvénients des pixels d'affichage à diodes électroluminescentes existants.

Un objet d'un mode de réalisation est que le nombre d'opérations de mise en place des pixels d'affichage sur la dalle de l'écran d'affichage est réduit.

Un objet d'un mode de réalisation est que les contraintes de précision pour la connexion des pixels d'affichage à une dalle sont réduites.

Un mode de réalisation prévoit un bloc d'affichage comprenant :
- un circuit optoélectronique comprenant des diodes électroluminescentes d'au moins deux pixels d'affichage et ayant une première face d'émission des rayonnements lumineux des diodes électroluminescentes ; et
- des structures diffusantes recouvrant le circuit optoélectronique, chaque structure diffusante étant au contact d'une partie de la première face d'émission et ayant une deuxième face d'émission des rayonnements lumineux des diodes électroluminescentes de l'un des pixels d'affichage, le rapport entre la somme des aires des deuxièmes faces d'émission et l'aire de la première face d'émission étant supérieure à 2.

Ceci permet d'utiliser des pixels d'affichage de petites dimensions tout en conservant une surface d'émission importante pour chaque pixel d'affichage.

Selon un mode de réalisation, les pixels d'affichage sont séparés par des premiers éléments de séparation ne laissant pas passer les rayonnements lumineux des diodes électroluminescentes et les structures diffusantes sont séparées par des deuxièmes éléments de séparation ne laissant pas passer les rayonnements lumineux des diodes électroluminescentes, les premiers éléments de séparation étant alignés avec les deuxièmes éléments de séparation au niveau de la première face d'émission. Chaque structure diffusante peut recevoir seulement le rayonnement lumineux des diodes électroluminescentes de l'un des pixels d'affichage. Ceci permet d'éviter la diaphonie optique entre les pixels d'affichage d'un même bloc d'affichage.

Chaque structure diffusante vise à répartir les rayonnements lumineux émis par les diodes électroluminescentes du pixel d'affichage au contact de cette structure diffusante sur la totalité de la deuxième face d'émission associée à la structure diffusante. Selon un mode de réalisation, la deuxième face d'émission est une surface diffusante. Selon un mode de réalisation, chaque structure diffusante est au moins en partie composée d'un matériau diffusant. Selon un mode de réalisation, chaque structure diffusante est au moins en partie composée d'un guide d'ondes. Selon un mode de réalisation, chaque structure diffusante comprend des motifs répartis sur une surface et réfléchissant ou diffusant les rayonnements lumineux. Selon un mode de réalisation, la densité de surface des motifs augmente en s'éloignant du circuit optoélectronique.

Selon un mode de réalisation, le bloc d'affichage comprend une gaine isolante électriquement entourant le circuit optoélectronique, les structures diffusantes recouvrant la gaine, au contact de la gaine ou séparée de la gaine par un film d'air par l'intermédiaire d'espaceurs interposés entre la gaine et les structures diffusantes.

Selon un mode de réalisation, le circuit optoélectronique comprend une troisième face opposée à la première face et des premiers plots conducteurs électriquement exposés sur la troisième face, le bloc d'affichage comprenant des pistes conductrices électriquement au contact des premiers plots conducteurs électriquement et se prolongeant par des deuxièmes plots conducteurs électriquement s'étendant sur la gaine.

Un mode de réalisation prévoit un bloc d'affichage comprenant :
- un circuit optoélectronique comprenant des diodes électroluminescentes d'au moins un pixel d'affichage, une première face d'émission des rayonnements lumineux des diodes électroluminescentes, une troisième face opposée à la première face, et des premiers plots conducteurs électriquement exposés sur la troisième face ;
- une gaine isolante électriquement entourant le circuit optoélectronique ; et
- des pistes conductrices électriquement au contact des premiers plots conducteurs électriquement et se prolongeant par des deuxièmes plots conducteurs électriquement s'étendant sur la gaine.

L'écart entre les deuxièmes plots conducteurs peut être augmenté par rapport à l'écart entre les premiers plots conducteurs. Ceci facilite la pose ultérieure des blocs de pixels sur une dalle, en diminuant les contraintes quant à la précision du positionnement des blocs de pixels au moment du transfert sur dalle.

Selon un mode de réalisation, au moins l'une des structures diffusantes contient des luminophores. Selon un mode de réalisation, les luminophores comprennent des boîtes quantiques. Selon un mode de réalisation, au moins deux structures diffusantes contiennent des luminophores différents. Selon un mode de réalisation, les diodes électroluminescentes émettent chacune un premier rayonnement lumineux à une première longueur d'onde, et dans lequel les structures diffusantes comprennent une première structure diffusante comprenant des premiers luminophores adaptés à convertir le premier rayonnement lumineux en un deuxième rayonnement lumineux à une deuxième longueur d'onde différente de la première longueur d'onde et une deuxième structure diffusante comprenant des deuxièmes luminophores adaptés à convertir le premier rayonnement lumineux en un troisième rayonnement lumineux à une troisième longueur d'onde différente de la première longueur d'onde et de la deuxième longueur d'onde.

Selon un mode de réalisation, les pixels d'affichage du circuit optoélectronique sont jointifs et la première face d'émission est centrée par rapport à la surface formée par les deuxièmes faces d'émission. Selon un mode de réalisation, le circuit optoélectronique comprend quatre pixels d'affichage.

Selon un mode de réalisation, le circuit optoélectronique comprend un seul circuit de commande de toutes les diodes électroluminescentes des pixels d'affichage. Le circuit optoélectronique comprend donc les diodes électroluminescentes associées à plusieurs pixels d'affichage qui sont commandés par le même circuit de commande. Ceci permet de façon avantageuse de réduire le nombre de plots conducteurs nécessaire pour l'alimentation/la commande de ces pixels d'affichage. Ceci facilite la pose ultérieure des blocs de pixels sur une dalle, en diminuant les contraintes quant à la précision du positionnement des blocs de pixels au moment du transfert sur dalle.

Un mode de réalisation prévoit également un écran d'affichage comprenant une dalle et une pluralité de blocs d'affichage, tels que définis précédemment, fixés à la dalle.

Selon un mode de réalisation, les pixels d'affichage des blocs d'affichage sont agencés en rangées et en colonnes, et le circuit optoélectronique de chaque bloc d'affichage comprend au moins quatre pixels d'affichage appartenant à au moins deux rangées adjacentes et à au moins deux colonnes adjacentes.

Un mode de réalisation prévoit également un procédé de fabrication de blocs d'affichage tels que définis précédemment, comprenant les étapes suivantes :
a) formation d'une plaque comprenant une pluralité desdits circuits optoélectroniques ;
b) découpage de la plaque pour séparer lesdits circuits optoélectroniques ; et
c) pour chaque circuit optoélectronique séparé, formation des structures diffusantes recouvrant le circuit optoélectronique.

Selon un mode de réalisation, le procédé comprend, en outre, à l'étape a), la formation de premiers éléments de séparation dans chaque circuit optoélectronique séparant les pixels d'affichage, et, à l'étape c), la formation de deuxièmes éléments de séparation séparant les structures diffusantes et alignés avec les premiers éléments de séparation.

Un mode de réalisation prévoit également un procédé de fabrication d'un écran d'affichage tel que défini précédemment comprenant la mise en place des blocs d'affichage sur la dalle. Le nombre réduit de premiers plots conducteurs par pixels d'affichage, et la formation des deuxièmes plots conducteurs permet d'augmenter l'écart entre les deuxièmes plots conducteurs. Ceci facilite la pose des blocs d'affichage sur une dalle, en diminuant les contraintes quant à la précision du positionnement des blocs d'affichage au moment du transfert sur la dalle.

Selon un mode de réalisation, la gaine entoure complètement le circuit optoélectronique et la dimension minimale de la gaine dans un plan parallèle à la troisième face est comprise entre 5 µm et 5 mm. Selon un mode de réalisation, la dimension maximale du circuit optoélectronique dans un plan parallèle à la troisième face est comprise entre 10 µm et 200 µm et la dimension maximale du bloc d'affichage dans ledit plan parallèle à la troisième face est comprise entre 100 µm et 500 µm. Selon un mode de réalisation, l'écart maximal entre les centres des premiers plots conducteurs électriquement est compris entre 0,5 µm et 2 mm et l'écart minimal entre les centres des deuxièmes plots conducteurs électriquement est compris entre 1 µm et 5 mm, de préférence entre 5 µm et 3 mm.

Selon un mode de réalisation, le circuit optoélectronique comprend seulement quatre premiers plots conducteurs électriquement.

Un mode de réalisation prévoit également un procédé de fabrication de blocs d'affichage tels que définis précédemment, comprenant les étapes suivantes :
a') formation d'une plaque comprenant une pluralité desdits circuits optoélectroniques ;
b') découpage de la plaque pour séparer lesdits circuits optoélectroniques ; et
c') pour chaque circuit optoélectronique séparé, formation de la gaine isolante électriquement entourant le circuit optoélectronique ; et
d') pour chaque circuit optoélectronique séparé, formation des pistes conductrices électriquement au contact des premiers plots conducteurs électriquement et se prolongeant par les deuxièmes plots conducteurs électriquement s'étendant sur la gaine.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon partielle et schématique, un exemple d'écran d'affichage ;
la figure 2 est une vue de dessus, partielle et schématique, d'un exemple d'agencement de pixels d'affichage d'un écran d'affichage ;
la figure 3 est une vue de dessus, partielle et schématique, d'un autre exemple d'agencement de pixels d'affichage d'un écran d'affichage ;
la figure 4 est une coupe latérale, partielle et schématique, d'un mode de réalisation d'un groupe de pixels ;
la figure 5 est une vue de dessus, partielle et schématique, du mode de réalisation du groupe de pixels de la figure 4 ;
la figure 6 est une vue de dessous, partielle et schématique, du mode de réalisation du groupe de pixels de la figure 4 ;
la figure 7 est une vue de dessus, partielle et schématique, d'un mode de réalisation d'un d'écran d'affichage ;
la figure 8 est une vue en coupe, partielle et schématique, illustrant un mode de réalisation d'une structure diffusante ;
la figure 9 une vue en coupe, partielle et schématique, illustrant un autre mode de réalisation d'une structure diffusante ;
la figure 10 est une vue en coupe, partielle et schématique, illustrant un autre mode de réalisation d'une structure diffusante ;
la figure 11 est une vue en coupe, partielle et schématique, illustrant un autre mode de réalisation d'une structure diffusante ;
la figure 12 est une vue en coupe, partielle et schématique, illustrant un autre mode de réalisation d'une structure diffusante ;
la figure 13 est une vue en coupe, partielle et schématique, illustrant un autre mode de réalisation d'une structure diffusante ;
la figure 14 est une vue en coupe, partielle et schématique, d'un mode de réalisation plus détaillé de la structure d'un pixel d'affichage du groupe de pixels de la figure 4 ;
la figure 15 illustre une étape d'un mode de réalisation d'un procédé de fabrication d'un écran d'affichage ;
la figure 16 illustre une autre étape du procédé ;
la figure 17 illustre une autre étape du procédé ;
la figure 18 illustre une autre étape du procédé ;
la figure 19 illustre une autre étape du procédé ;
la figure 20 illustre une autre étape du procédé ;
la figure 21 illustre une autre étape du procédé ;
la figure 22 illustre une autre étape du procédé ;
la figure 23 illustre une autre étape du procédé ;
la figure 24 illustre une autre étape du procédé ;
la figure 25 illustre une autre étape du procédé ;
la figure 26 illustre une autre étape du procédé ;
la figure 27 représente une image affichée par un écran d'affichage connu ;
la figure 28 représente l'image affichée par un écran d'affichage connu à pixels d'affichage à diodes électroluminescentes ;
la figure 29 représente l'image affichée par un écran d'affichage connu à pixels d'affichage à diodes électroluminescentes ;
la figure 30 représente l'image affichée sur un écran d'affichage comprenant les groupes de pixels de la figure 4 selon un agencement des groupes de pixels ;
la figure 31 représente l'image affichée sur un écran d'affichage comprenant les groupes de pixels de la figure 4 selon un autre agencement des groupes de pixels ; et
la figure 32 représente l'image affichée sur un écran d'affichage comprenant les groupes de pixels de la figure 4 selon un autre agencement des groupes de pixels.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments. En outre, on considère ici que les termes "isolant" et "conducteur" signifient respectivement "isolant électriquement" et "conducteur électriquement".

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un écran d'affichage dans une position normale d'utilisation.

Sauf précision contraire, les expressions "environ", "approximativement", "sensiblement", et "de l'ordre de" signifient à 10 % près, de préférence à 5 % près.

Dans la suite de la description, la transmittance interne d'une couche correspond au rapport entre l'intensité du rayonnement sortant de la couche et l'intensité du rayonnement entrant dans la couche. L'absorption de la couche est égale à la différence entre le chiffre 1 (ce qui correspond à une transmittance parfaite pour laquelle toute la lumière incidente est transmise) et la transmittance interne. Dans la suite de la description, une couche est dite transparente à un rayonnement lorsque l'absorption du rayonnement au travers de la couche est inférieure à 75 %. Dans la suite de la description, une couche est dite absorbante ou opaque à un rayonnement lorsque l'absorption du rayonnement dans la couche est supérieure à 75 %. Dans la suite de la description, l'indice de réfraction d'un matériau correspond à l'indice de réfraction du matériau pour la plage de longueurs d'onde du rayonnement émis par la source lumineuse. Sauf indication contraire, l'indice de réfraction est considéré sensiblement constant sur la plage de longueurs d'onde du rayonnement émis par la source lumineuse, par exemple égal à la moyenne de l'indice de réfraction sur la plage de longueurs d'onde du rayonnement émis par la source lumineuse.

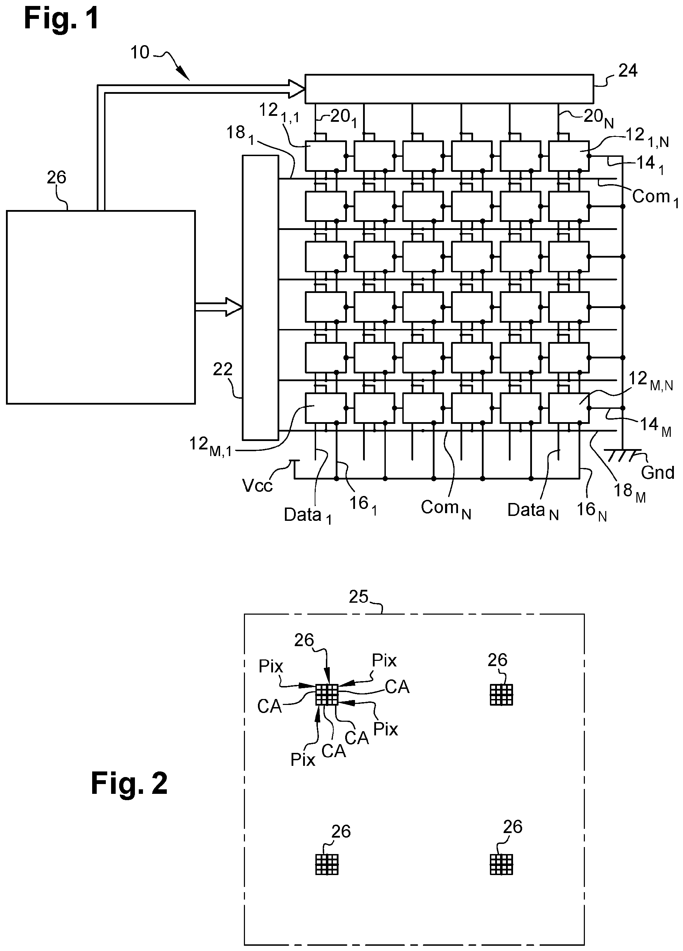

La figure 1 représente, de façon partielle et schématique, un exemple d'écran d'affichage 10. L'écran d'affichage 10 comprend des pixels d'affichage 12_{i,j} par exemple agencés en M rangées et en N colonnes, M étant un nombre entier variant de 1 à 8000 et N étant un nombre entier variant de 1 à 16000, i étant un nombre entier variant de 1 à M et j étant un nombre entier variant de 1 à N. A titre d'exemple, en figure 1, M et N sont égaux à 6. Chaque pixel d'affichage 12_{i,j} est relié à une source d'un potentiel de référence bas Gnd, par exemple la masse, par l'intermédiaire d'une électrode 14ᵢ et à une source d'un potentiel de référence haut Vcc par l'intermédiaire d'une électrode 16ⱼ. A titre d'exemple, les électrodes 14ᵢ sont représentées alignées selon les rangées en figure 1 et les électrodes 16ⱼ sont représentées alignées selon les colonnes en figure 1, la disposition inverse étant possible. La tension d'alimentation de l'écran d'affichage correspond à la tension entre le potentiel de référence haut Vcc et le potentiel de référence bas Gnd.

Pour chaque rangée, les pixels d'affichage 12_{i,j} de la rangée sont reliés à une électrode de rangée 18ᵢ. Pour chaque colonne, les pixels d'affichage 12_{i,j} de la colonne sont reliées à une électrode de colonne 20ⱼ. L'écran d'affichage 10 comprend un circuit de sélection 22 relié aux électrodes de rangée 18ᵢ et adapté à fournir un signal de sélection et de cadencement Comᵢ sur chaque électrode de rangée 18ᵢ. L'écran d'affichage 10 comprend un circuit de fourniture de données 24 relié aux électrodes de colonne 20ⱼ et adapté à fournir un signal de données Dataⱼ sur chaque électrode de colonne 20ⱼ. Le circuit de sélection 22 et le circuit de commande 24 sont commandés par un circuit 23, comprenant par exemple un microprocesseur.

Lorsque les pixels d'affichage correspondent à des pixels intelligents, le procédé de fabrication peut comprendre la mise en place individuelle de chaque pixel d'affichage sur une dalle. La dalle peut comprendre des pistes conductrices, chaque pixel d'affichage étant fixé à la dalle de façon à connecter des plots de contact du pixel d'affichage aux pistes conductrices. Avec la tendance à l'augmentation de la résolution des écrans d'affichage, le nombre d'opérations de mise en place individuelle des pixels d'affichage peut être important, augmentant la durée et le coût de la fabrication de l'écran d'affichage.

Chaque pixel d'affichage peut comprendre un circuit de commande recouvert d'un circuit d'affichage. Le circuit d'affichage comprend au moins une diode électroluminescente LED, de préférence au moins trois diodes électroluminescentes LED. Le circuit de commande peut correspondre à un circuit intégré comprenant des composants électroniques, notamment des transistors à effet de champ à grille isolée, également appelés transistors MOS, ou des transistors en couches minces, également appelés transistors TFT (sigle anglais pour Thin-Film Transistor). Le circuit de commande comprend en outre les plots de contact. Un procédé de fabrication du pixel d'affichage comprend la formation d'une pluralité de circuits d'affichage sur une plaque, appelée plaque optoélectronique, la formation d'une pluralité de circuits de commande sur une plaque, appelée plaque logique, la fixation de la plaque optoélectronique à la plaque logique et la découpe de l'empilement de la plaque optoélectronique et de la plaque logique pour séparer les pixels d'affichage.

Une possibilité pour réduire le nombre d'opérations de mise en place de pixels d'affichage sur la dalle de l'écran d'affichage consiste à rassembler plusieurs pixels d'affichage en un groupe de pixels d'affichage solidaires, chaque groupe de pixels comprenant par exemple quatre pixels d'affichage. Lorsque les pixels d'affichage sont fabriqués à partir de l'empilement d'une plaque optoélectronique et d'une plaque logique comme cela a été décrit précédemment, cela revient à découper l'empilement de la plaque optoélectronique et de la plaque logique pour séparer les groupes de pixels au lieu de séparer les pixels d'affichage individuellement. Les opérations de mise en place sont réalisées sur les groupes de pixels d'affichage au lieu des pixels d'affichage individuels. Le nombre de manipulations est ainsi réduit. Chaque groupe de pixels comprend alors un empilement d'un circuit global de commande intégrant les circuits de commande des pixels d'affichage du groupe de pixels et un circuit global d'affichage comprenant les circuits d'affichage des pixels d'affichage du groupe de pixels.

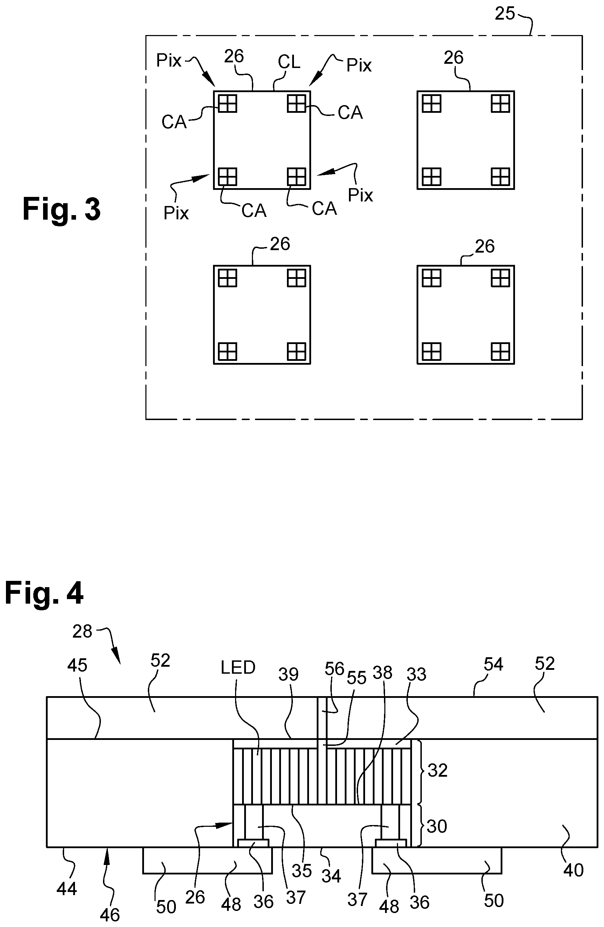

Les figures 2 et 3 sont chacune une vue de dessus schématique d'une partie d'un exemple d'écran d'affichage 25 comprenant des groupes de pixels 26, quatre groupes de pixels 26 étant représentés sur les figures 2 et 3, chaque groupe de pixels 26 comprenant quatre pixels d'affichage Pix.

En figure 2, les diodes électroluminescentes CA des pixels d'affichage Pix de chaque groupe de pixels 26 sont jointives. Un inconvénient est que, lorsque les dimensions latérales des pixels d'affichage Pix sont réduites, les pixels d'affichage Pix d'un même groupe de pixels 26 peuvent ne pas être distingués individuellement par un observateur qui percevra alors un pixel d'image unique.

En figure 3, chaque groupe de pixels 26 comprend un circuit logique CL, sur lequel sont disposées les diodes électroluminescentes CA des pixels d'affichage, ayant des dimensions latérales suffisamment importantes pour que les diodes électroluminescentes CA des pixels d'affichage d'un même groupe de pixels 26 ne soient pas jointives. Les pixels d'affichage Pix d'un même groupe de pixels 26 peuvent ainsi être distingués individuellement par un observateur qui percevra alors des pixels d'image distincts. Un inconvénient est qu'une partie importante de la surface, en vue de dessus, du groupe de pixels 26 ne participe pas à l'émission de lumière alors qu'elle présente un coût en terme de fabrication du circuit global de commande et du circuit global d'affichage.

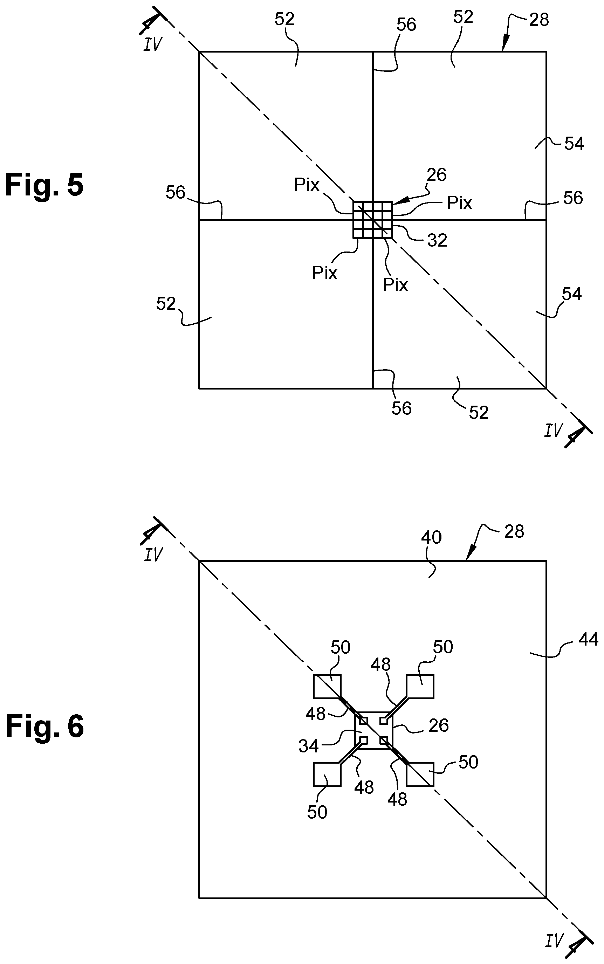

Les figures 4, 5, et 6 sont des vues, partielles et schématiques, respectivement en coupe latérale, de dessus, et de dessous d'un mode de réalisation d'un bloc 28 de pixels. La coupe de la figure 4 est réalisée selon la ligne IV-IV sur les figures 5 et 6.

Le bloc 28 comprend un groupe 26 de pixels, qui comprend au moins deux pixels d'affichage. Sur les figures 4, 5, et 6, le groupe de pixels 26 comprend quatre pixels d'affichage Pix. Le groupe de pixels 26 comprend un circuit global de commande 30, qui intègre les circuits de commande des pixels d'affichage Pix et qui est recouvert par un circuit global d'affichage 32 qui intègre les circuits d'affichage des pixels d'affichage Pix. Selon un mode de réalisation, les pixels d'affichage peuvent être commandés indépendamment les uns des autres. Le circuit global de commande 30 est alors configuré pour commander les pixels d'affichage indépendamment les uns des autres.

Le circuit global de commande 30 comprend une face inférieure 34 et une face supérieure 35 opposée à la face inférieure 34, les faces 34 et 35 étant de préférence parallèles. La face inférieure 34 du circuit global de commande 30 forme la face inférieure du groupe de pixels 26. Le circuit global de commande 30 comprend en outre des plots conducteurs 36 exposés sur la face inférieure 34. Le circuit global de commande 30 peut comprendre un substrat semiconducteur, non représenté, recouvert d'au moins un niveau de métallisation, non représenté. En particulier, le circuit global de commande 30 peut correspondre à un circuit intégré comprenant des composants électroniques, notamment des transistors MOS, ou des transistors TFT. Le circuit global de commande 30 peut en outre comprendre des vias conducteurs traversant 37 s'étendant sur une partie de l'épaisseur du circuit global de commande 30 et permettant de connecter les plots conducteurs 36 à d'autres composants électroniques du circuit global de commande ou de connecter les plots conducteurs 36 directement au circuit global d'affichage 32.

Le circuit global d'affichage 32 comprend une face inférieure 38 et une face supérieure 39 opposée à la face inférieure 38, les faces 38 et 39 étant de préférence parallèles. La face supérieure 39 du circuit global d'affichage 32 forme la face supérieure du groupe de pixels 26. La face inférieure 38 du circuit global d'affichage 32 est fixée à la face supérieure 35 du circuit global de commande 30.

Le circuit global d'affichage 32 comprend pour chaque pixel d'affichage Pix au moins une diode électroluminescente LED, de préférence au moins trois diodes électroluminescentes LED. Le circuit global d'affichage 32 peut comprendre une structure monocouche ou multicouches 33 recouvrant les diodes électroluminescentes LED et formant la face supérieure 39. La majorité, de préférence la totalité, des rayonnements émis par les diodes électroluminescentes LED des pixels d'affichage, est émis par la face supérieure 39 du circuit global d'affichage 32. De préférence, le circuit global d'affichage 32 comprend seulement les diodes électroluminescentes LED, et les éléments conducteurs de ces diodes électroluminescentes LED et le circuit global de commande 30 comprend la totalité des composants électroniques nécessaires à la commande des diodes électroluminescentes LED du circuit global d'affichage 32. A titre de variante, le circuit global d'affichage 32 peut également comprendre d'autres composants électroniques en plus des diodes électroluminescentes LED. Les diodes électroluminescentes LED peuvent être des diodes électroluminescentes 2D, également appelées diodes électroluminescentes planaires, comprenant un empilement de couches planes, ou des diodes électroluminescentes 3D comprenant chacune un élément semiconducteur tridimensionnel recouvert d'une zone active.

Le bloc de pixels 28 comprend, en outre, une gaine 40 entourant le groupe de pixels 26. La gaine 40 s'étendant sur la totalité des faces latérales du groupe de pixels 26. La gaine 40 comprend une face inférieure 44 et une face supérieure 45 opposée à la face inférieure 44, les faces 44 et 45 étant de préférence planes et parallèles. La face inférieure 44 de la gaine 40 forme, avec la face inférieure 34 du groupe de pixels 26, une face inférieure 46 du bloc de pixels 28, également appelée face de contact par la suite. De préférence, la face inférieure 44 de la gaine 40 et la face inférieure 34 du groupe de pixels 26 sont planes et coplanaires, de sorte que la face de contact 46 est plane. De préférence, la face supérieure 45 de la gaine 40 et la face supérieure 39 du groupe de pixels 26 sont planes et coplanaires. La gaine 40 est de préférence un matériau isolant. A titre d'exemple, la gaine 40 est en oxyde de silicium (SiO₂).

Le bloc de pixels 28 comprend des pistes conductrices 48 et des plots conducteurs 50, quatre pistes conductrices 48 et quatre plots conducteurs 50 étant représentés à titre d'exemple en figure 6. Les piste conductrices 48 s'étendent sur la face inférieure 34 du groupe de pixels 26 et sur la face inférieure 44 de la gaine 40 et les plots conducteurs 50 reposent sur la face inférieure 44 de la gaine 40. Chaque piste 48 est connectée, à une extrémité, à l'un des plots conducteurs 50 et est connectée, à une première extrémité, à l'un des plots conducteurs 36 du groupe de pixels 26. Les pistes conductrices 48 et des plots conducteurs 50 sont par exemple en aluminium (Al) ou en cuivre (Cu).

Le bloc de pixels 28 comprend, en outre, des structures diffusantes 52, le nombre de structures diffusantes 52 étant égal au nombre de pixels d'affichage Pix du groupe de pixels 26. Chaque structure diffusante 52 reçoit le rayonnement émis par l'un des pixels d'affichage Pix. Chaque structure diffusante 52 recouvre une partie de la face supérieure 45 de la gaine 40 et une partie de la face supérieure 39 du groupe de pixels 26. La transmission du rayonnement du circuit global d'affichage 32 du groupe de pixels 26 vers les structures diffusantes 52 a notamment lieu par la face supérieure 39 du groupe de pixels 26 en contact avec les structures diffusantes 52. Chaque structure diffusante 52 comprend une face supérieure 54 pour l'émission du rayonnement émis par l'un des pixels d'affichage Pix.

Le bloc de pixels 28 comprend des premiers éléments de séparation 55 présents dans le circuit global d'affichage 32 et séparant les pixels d'affichage Pix, et des deuxièmes éléments de séparation 56 séparant les structures diffusantes 52. Les premiers et deuxièmes éléments de séparation 55, 56 ne laissent pas passer le rayonnement émis par les diodes électroluminescentes LED. Les premiers éléments de séparation 55 sont alignés avec les deuxièmes éléments de séparation 56. Les premiers éléments de séparation 55 s'étendent par exemple sur la majorité, de préférence sur au moins 75 %, plus préférentiellement sur la totalité, de l'épaisseur de la structure monocouche ou multicouches 33 et des diodes électroluminescentes LED jusqu'au circuit global de commande 30. Les deuxièmes éléments de séparation 56 peuvent correspondre à des tranchées remplies d'air s'étendant sur toute l'épaisseur des structures diffusantes 52, ou des murs réfléchissants le rayonnement émis par les pixel d'affichage. Ces éléments de séparation 55, 56 permettent ainsi d'éviter que la lumière émise par un pixel d'affichage Pix ne diffuse sur le pixel d'affichage adjacent, ce qui modifierait son spectre et son intensité d'émission, et nuirait à la netteté de l'image affichée. Selon un mode de réalisation, toutes les parois latérales de chaque structure diffusante 52 ne laissent pas passer le rayonnement émis par les diodes électroluminescentes LED. Dans ce but, les parois latérales extérieures de la structure diffusante 52 peuvent être recouvertes d'un revêtement opaque au rayonnement émis par les diodes électroluminescentes LED et/ou réfléchissant le rayonnement émis par les diodes électroluminescentes LED et/ou d'un film d'air. Ceci permet d'éviter la diaphonie optique entre blocs de pixels 28 adjacents.

Pour chaque pixel d'affichage Pix, la structure diffusante 52 remplit partiellement une fonction de guide d'ondes du rayonnement émis par le pixel d'affichage Pix de façon que, en fonctionnement, sensiblement au moins 50 %, de préférence au moins 75 %, plus préférentiellement au moins 90 %, encore plus préférentiellement 100 % de la face 54 de la structure diffusante 52 émette de la lumière. Le rapport entre la somme des aires des faces d'émission 54 des structures diffusantes 52 et l'aire de la face supérieure 39 du groupe de pixels 26 est supérieure à 2, de préférence supérieure à 5, de préférence supérieure à 50, plus préférentiellement supérieure à 500.

Selon un mode de réalisation, chaque pixel d'affichage comprend des premier, deuxième et troisième sous-pixels d'affichage adaptés à émettre des rayonnements à des première, deuxième, et troisième longueurs d'ondes. Selon un mode de réalisation, la première longueur d'onde correspond à de la lumière bleue, c'est-à-dire un rayonnement dont la longueur d'onde est dans la plage de 430 nm à 490 nm. Selon un mode de réalisation, la deuxième longueur d'onde correspond à de la lumière verte et est dans la plage de 510 nm à 570 nm. Selon un mode de réalisation, la troisième longueur d'onde correspond à de la lumière rouge et est dans la plage de 600 nm à 720 nm.

La gaine 40 peut être réfléchissante pour le rayonnement émis par les pixels d'affichage. A titre d'exemple, la gaine 40 peut être composée d'un matériau opaque et réfléchissant pour le rayonnement émis par les pixels d'affichage. La gaine 40 peut être en un matériau transparent ou diffusant. Dans ce cas, une partie du rayonnement émis par le circuit global d'affichage 32 peut parvenir jusqu'aux structures diffusantes 52 en passant par la gaine 40. De préférence, les éléments de séparation 55 comprennent alors en outre des troisièmes éléments de séparation s'étendant dans la gaine 40 dans le prolongement des deuxièmes éléments de séparation 56. A titre de variante, un mur réfléchissant pour le rayonnement émis par les pixels d'affichage peut être interposé entre la gaine 40 et les parois latérales du groupe de pixels 26 pour éviter qu'une partie du rayonnement émis par le circuit global d'affichage 32 ne pénètre dans la gaine 40.

Le bloc de pixels 28 peut avoir une forme générale cylindrique avec une section droite pouvant avoir différentes formes, telles que, par exemple, une forme ovale, circulaire ou polygonale, notamment triangulaire, rectangulaire, carrée ou hexagonale. A titre d'exemple, sur les figures 5 et 6, le bloc de pixels 28 est représenté avec une section droite carrée. Le groupe de pixels 26 peut avoir une forme générale cylindrique avec une section droite pouvant avoir différentes formes, telles que, par exemple, une forme ovale, circulaire ou polygonale, notamment triangulaire, rectangulaire, carrée ou hexagonale. A titre d'exemple, sur les figures 5 et 6, le groupe de pixels 26 est représenté avec une section droite carrée. La dimension latérale maximale du bloc de pixels 28 en vue de dessus peut être comprise entre 100 µm et 500 µm . La dimension latérale maximale du groupe de pixels 26 en vue de dessus peut être comprise entre 10 µm et 200 µm. La gaine 40 peut entourer complètement le groupe de pixels 26 et la dimension minimale de la gaine 40 dans le plan de la face inférieure 34 peut être comprise entre 5 µm et 5 mm. L'épaisseur du bloc de pixels 28 peut être comprise entre 20 µm et 750 µm. L'épaisseur du groupe de pixels 26 peut être comprise entre 20 µm et 750 µm. L'épaisseur de la gaine 40 mesurée de façon orthogonale à la face inférieure 34 peut être identique à l'épaisseur du groupe de pixels 26. L'épaisseur du circuit global de commande 30 peut être comprise entre 10 µm et 725 µm. L'épaisseur du circuit global d'affichage 32 peut être comprise entre 10 µm et 725 µm. En vue de dessous, la distance entre le centre d'un plot 50 et le centre du groupe de pixels 26 peut être comprise entre 50 µm et 300 µm. L'épaisseur de chaque élément de séparation 56, 55 mesurée dans la vue de dessus, peut être comprise entre 2 µm et 3 µm. L'écart maximal entre les centres des plots conducteurs électriquement 36 peut être compris entre 0,5 µm et 2 mm et l'écart minimal entre les centres des plots 50 peut être compris entre 1 µm et 5 mm, de préférence entre 5 µm et 3 mm.

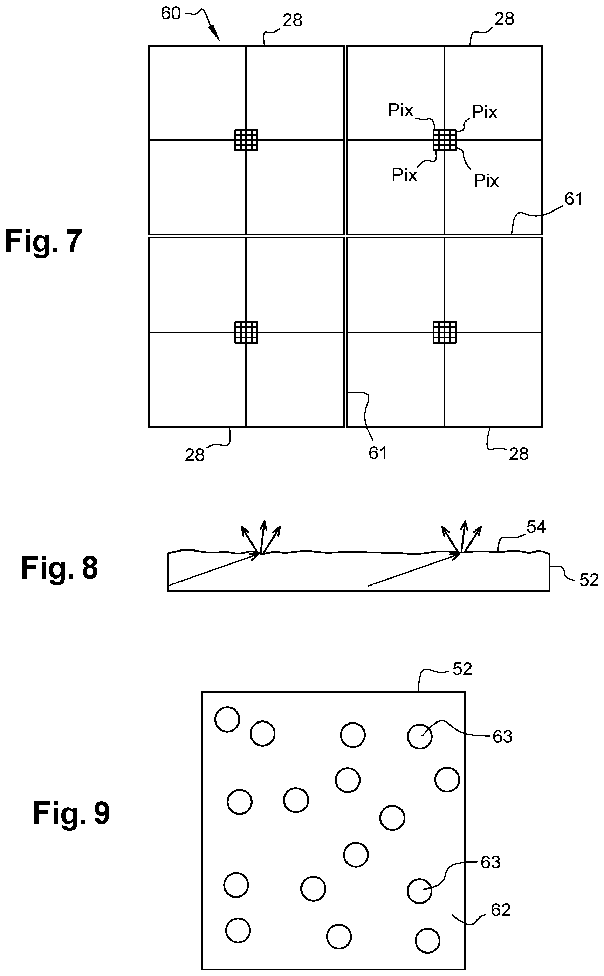

La figure 7 est une vue de dessus schématique d'une partie d'un exemple d'écran d'affichage 60 comprenant des blocs de pixels 28, quatre blocs de pixels 28 étant représentés sur la figure 7, chaque bloc de pixels 28 comprenant quatre pixels d'affichage Pix. Un interstice 61 peut être présent entre deux blocs de pixels 28 adjacents. L'interstice 61 peut avoir une épaisseur comprise entre 1 µm et 50 µm. Au moins 50 %, de préférence au moins 75 %, de la surface de l'écran d'affichage 60 vue par un observateur correspond à des surfaces d'émission de groupes de pixels 26. Les pixels d'affichage Pix d'un même groupe de pixels 26 peuvent ainsi être distingués individuellement par un observateur qui percevra alors des pixels d'image distincts. En outre, la totalité de la face supérieure 39 du groupe de pixels 26 participe à l'émission de lumière.

Chaque structure diffusante 52 peut avoir une structure monocouche ou une structure multicouche. On appelle pouvoir diffusant de la face 54 à un emplacement donné de la face 54 le pourcentage entre la puissance optique sortant de la face 54 pour une surface unitaire audit emplacement donné et la puissance optique injectée dans la structure diffusante 52 par le circuit global d'affichage 32. Selon un mode de réalisation, le pouvoir diffusant de la face 54 est compris entre 0,5 % et 50 % en n'importe quel emplacement de la face 54.

La figure 8 est une vue en coupe, partielle et schématique, d'un mode de réalisation de la structure diffusante 52. Selon un mode de réalisation, la structure diffusante 52 comprend une texturation sur la face d'émission 54. La structure diffusante 52 peut correspondre à une couche en un matériau transparent à laquelle est appliquée une texturation en surface. La texturation peut correspondre à un polissage. La couche en un matériau transparent peut être en polymère, en silicone, ou en oxyde de silicium. L'épaisseur de la couche en un matériau transparent peut être comprise entre 0,01 µm et 100 µm. La rugosité moyenne arithmétique Ra de la face d'émission 54 est comprise entre 0,1 µm et 5 µm.

Selon un mode de réalisation, chaque structure diffusante 52 est une couche en un matériau diffusant.

La figure 9 est une vue schématique illustrant un exemple de matériau diffusant comprenant une matrice 62 dans laquelle sont dispersées des particules réfléchissantes 63. La matrice 62 peut être en un matériau transparent aux rayonnements émis par les pixels d'affichage Pix. La matrice 62 peut comprendre de l'oxyde de silicium (SiO₂), un polymère silicone, un polymère époxyde, un polymère acrylique ou un polycarbonate. Les particules 63 sont par exemple des particules en oxyde de titane (TiO₂). L'épaisseur de la couche en un matériau diffusant peut être comprise entre 2 µm et 2 mm.

Chaque structure diffusante 52 peut au moins en partie avoir une structure de guide d'onde. Ceci permet de façon avantageuse de guider le rayonnement émis par pixel d'affichage Pix dans la totalité de la structure diffusante 52 pour que l'émission du rayonnement se produise sur la totalité de la face d'émission 54 correspondante.

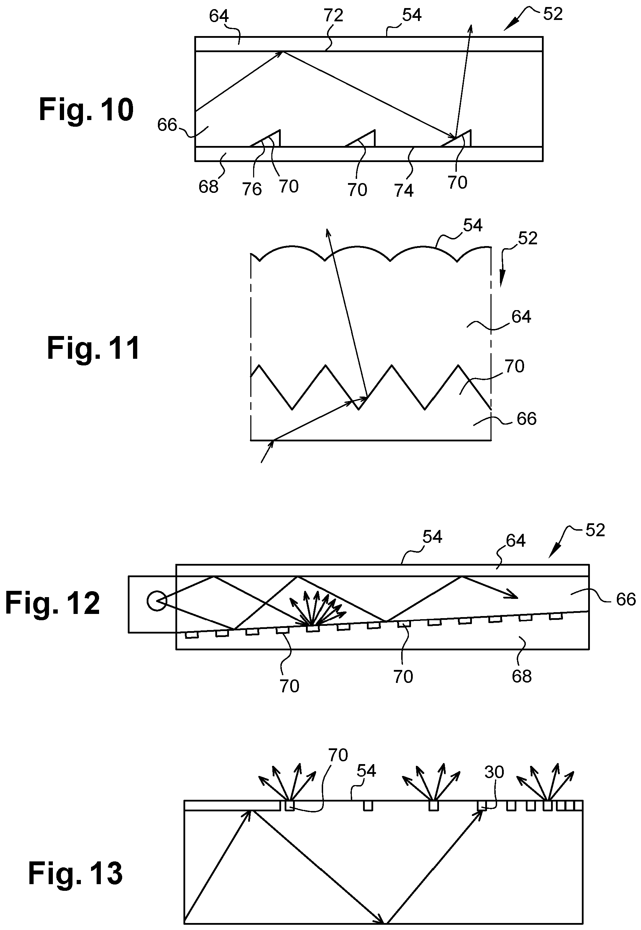

La figure 10 est une vue en coupe, partielle et schématique, d'un autre mode de réalisation de la structure diffusante 52 ayant en partie une structure de guide d'ondes et comprenant, du haut vers le bas :
- une gaine supérieure 64 délimitant la face d'émission 54 ;
- un coeur 66 ;
- une gaine inférieure 68, le coeur 66 étant pris en sandwich entre la gaine inférieure 68 et la gaine supérieure 64 ; et
- des motifs en relief 70 de taille micrométrique reposant sur la gaine inférieure 68 du côté du coeur 66.

Le coeur 66 peut avoir une structure monocouche ou une structure multicouche. Dans le cas où le coeur a une structure multicouche, toutes les couches composant le coeur 66 ont sensiblement le même indice de réfraction. La gaine supérieure 64, la gaine inférieure 68, et les motifs 70 peuvent être composés du même matériau ou de matériaux différents. Les motifs 70 peuvent être du même matériau que la gaine inférieure 68. En particulier, les motifs 70 et la gaine inférieure 68 peuvent constituer une structure monobloc. En particulier, les motifs 70 et la gaine inférieure 68 peuvent correspondre à un film d'air au moins pour la partie de la structure diffusante 52 en vis-à-vis de la gaine 40. A titre de variante, pour la partie de la structure diffusante 52 en vis-à-vis de la gaine 40, la gaine inférieure 68 correspond à un film d'air et des espaceurs interposés entre la gaine 40 et le coeur 66 forment les motifs 70. L'indice de réfraction du matériau composant le coeur 66 est supérieur à l'indice de réfraction du matériau composant la gaine supérieure 64, la gaine inférieure 68 et les motifs 70 ou, dans le cas où la gaine supérieure 64, la gaine inférieure 68 et/ou les motifs 70 sont en matériaux différents, des indices de réfraction des matériaux composant la gaine supérieure 64, la gaine inférieure 68 et les motifs 70. La gaine supérieure 64 peut ne pas être présente, la face d'émission 54 correspondant alors à la face supérieure du coeur 66. La gaine inférieure 68 peut ne pas être présente entre le coeur 66 et la gaine 40 et être remplacée par un film d'air entre le coeur 66 et la gaine 40, maintenu par des espaceurs interposés entre le coeur 66 et la gaine 40. L'indice de réfraction de la gaine inférieure 68 au contact de la face supérieure 39 du groupe de pixels 26 est inférieur à l'indice de réfraction de la structure monocouche ou multicouches 33. La gaine supérieure 64 comprend une face 72 au contact du coeur 66. De préférence, la face 72 est plane et parallèle à la face supérieure 54. La gaine inférieure 68 comprend une face 74 sur laquelle reposent les motifs 70 et qui est, en dehors des motifs 70, au contact du coeur 66. La gaine supérieure 64 peut en outre servir de revêtement de protection du coeur 66.

Les motifs 70 augmentent l'extraction du rayonnement injecté dans le guide d'ondes 52. Les motifs 70 peuvent avoir la même forme ou des formes différentes. A titre d'exemple, chaque motif 70 peut comprendre une face 76 plane inclinée par rapport à la face supérieure 54. A titre d'exemple, chaque motif 70 peut avoir une forme prismatique. A titre de variante, les motifs 70 peuvent reposer sur la gaine supérieure 64 du côté du coeur 66.

Selon un mode de réalisation, l'épaisseur du coeur 66 peut être comprise entre 2 µm et 1 mm. Selon un mode de réalisation, l'épaisseur de la gaine supérieure 64 peut être comprise entre 1 µm et 150 µm, de préférence entre 30 µm et 80 µm. Selon un mode de réalisation, l'épaisseur de la gaine inférieure 68 peut être comprise entre 1 µm et 150 µm. La hauteur maximale de chaque motif 70, mesurée par rapport à la face 74 peut être comprise entre 0,5 µm et 100 µm, de préférence entre 1 µm et 10 µm. Les motifs 70 peuvent avoir chacun une largeur inférieure à 20 µm, de préférence inférieure à 12 µm, plus préférentiellement entre 2 µm et 6 µm.

Selon un mode de réalisation, le coeur 66 peut être réalisé en polycarbonate (PC), polyméthacrylate de méthyle (PMMA), polytéréphtalate d'éthylène (PET), ou polymère d'oléfine cyclique (COP). Selon un mode de réalisation, la gaine supérieure 64, la gaine inférieure 68, et/ou les motifs 70 peuvent être réalisés à partir d'un adhésif optiquement transparent (Optically Clear Adhesive - OCA), notamment un adhésif optiquement transparent liquide (Liquid Optically Clear Adhesive - LOCA), ou d'un matériau à bas indice de réfraction, ou d'une colle epoxy/acrylate, ou d'un film d'un gaz ou d'un mélange gazeux. Selon un mode de réalisation, l'indice de réfraction du coeur 66 est compris entre 1,45 et 1,7, et l'indice de réfraction de la gaine supérieure 64, de la gaine inférieure 66, et des motifs 70 est compris entre 1 et 1,55. La différence entre l'indice de réfraction du coeur 66 et l'indice de réfraction de la gaine supérieure 64, de la gaine inférieure 66, et des motifs 70 est supérieure à 0,07, de préférence supérieure à 0,1. Le guide d'ondes 52 peut être réalisé selon une procédure feuille à feuille, ou une procédure rouleau à rouleau. Les motifs 70 peuvent être réalisés par moulage sous pression ou par impression par jet d'encre.

La figure 11 est une vue en coupe, partielle et schématique, d'un autre mode de réalisation de la structure diffusante 52 ayant en partie une structure du guide d'ondes ayant une structure analogue à celle représentée en figure 10, à la différence que les motifs 70 sont prévus à l'interface entre le coeur 66 et la gaine supérieure 64. En outre, en figure 11, la face d'émission 54 présente une texturation améliorant la diffusion de la lumière émise. A titre d'exemple, la texturation comprend la formation d'empreintes dans la face supérieure 54 formant des lentilles de taille micrométrique.

La figure 12 est une vue en coupe, partielle et schématique, d'un autre mode de réalisation de la structure diffusante 52 ayant en partie une structure de guide d'ondes ayant une structure analogue à celle représentée en figure 10 à la différence que les motifs 70 favorisent la diffusion de la lumière guidée par le guide d'ondes. A titre de variante, les motifs 70 ne sont pas présents. Dans ce cas, l'interface entre la gaine inférieure 68 et le coeur 66 est inclinée par rapport à l'interface entre la gaine supérieure 64 68 et le coeur 66 et par rapport à la face d'émission 54.

La figure 13 est une vue en coupe, partielle et schématique, d'un autre mode de réalisation de la structure diffusante 52 ayant une structure analogue à celle représentée en figure 12 à la différence que les motifs 70 qui favorisent la dispersion de la lumière guidée par le guide d'ondes sont situés sur la face supérieure 54.

La densité surfacique des motifs 70 de la structure diffusante 52 peut ne pas être constante. En particulier, la densité surfacique des motifs 70 peut augmenter lorsqu'on s'éloigne de la zone d'injection du rayonnement dans la structure diffusante 52. A titre d'exemple, lorsque le rayonnement est injecté dans la structure diffusante 52 sur un bord de la structure diffusante 52, la densité surfacique des motifs 70 augmente en s'éloignant de ce bord. La variation de la densité surfacique de motifs permet de conserver une uniformité de la densité spectrale du flux du rayonnement avant émis par la face d'émission 54 alors que la densité spectrale du flux du rayonnement se propageant dans la structure diffusante 52 diminue au fur et à mesure que l'on s'éloigne de la zone d'injection de rayonnement dans la structure diffusante 52.

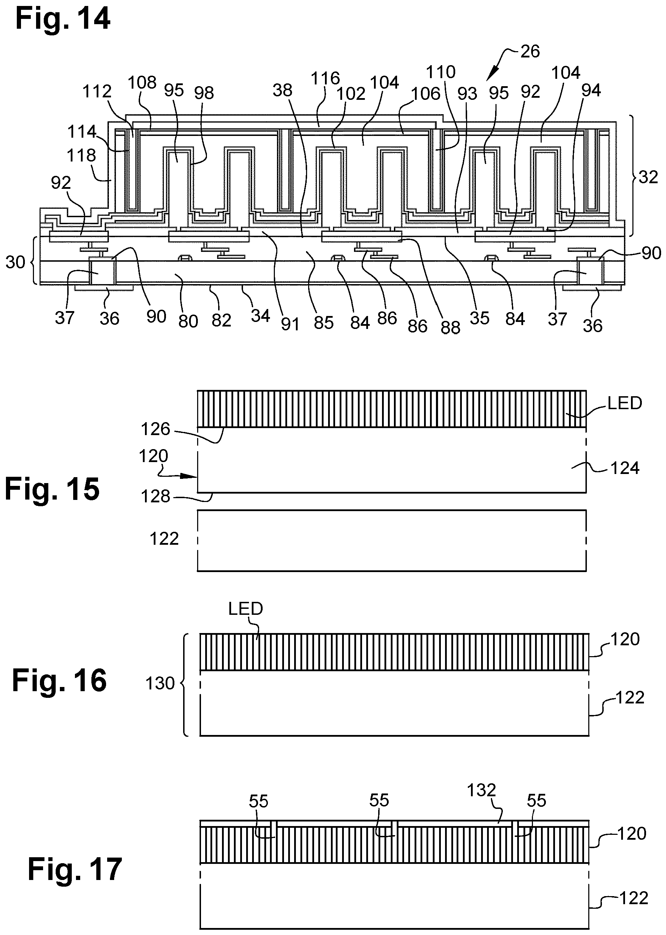

La figure 14 est une vue en coupe, partielle et schématique, d'un mode de réalisation plus détaillé du groupe de pixels 26 comprenant trois sous-pixels d'affichage.

Selon un mode de réalisation, le circuit global de commande 30 comprend de bas en haut en figure 14 :
- un substrat semiconducteur 80, par exemple du silicium monocristallin, une couche isolante 82 délimitant la face inférieure 34 et les plots conducteurs 36 exposés sur la face inférieure 34 ;
- des transistors MOS 84 ou d'autres types classiquement utilisés dans les circuits intégrés, par exemple des transistors bipolaires (BJT, sigle anglais pour Bipolar Junction Transistor), formés dans et sur le substrat 80. Ces transistors pourraient être aussi être des transistors en couches minces (TFT, sigle anglais pour Thin-Film Transistor) déposé sur un substrat d'une autre nature que le silicium, par exemple un substrat en polymère, ou même déposés directement sur la face arrière des diodes électroluminescentes LED. Dans ce cas les diodes électroluminescentes LED forment le substrat et le procédé de fabrication est fait en ordre inverse par rapport à ce qui a été décrit précédemment, c'est-à-dire les niveaux de métallisation d'abord (empilement 85) et les composants passifs et actifs en dernier ;
- un empilement 85 de couches isolantes, par exemple en oxyde de silicium et/ou en nitrure de silicium, recouvrant le substrat 80 et les pistes conductrices 86 de plusieurs niveaux de métallisation formées entre les couches isolantes de l'empilement 85 dont notamment des plots 88 exposés sur la face supérieure 35 du circuit global de commande 30, les pistes conductrices 86 du premier niveau de métallisation pouvant être en silicium polycristallin et former notamment les grilles des transistors MOS 82 et les pistes conductrices 86 des autres niveaux de métallisation pouvant être des pistes métalliques, par exemple en aluminium, en argent, en cuivre ou en zinc ; et
- les vias 37 conducteurs et isolés latéralement, également appelés TSV (sigle anglais pour Through Silicon Vias) traversant le substrat 80 et reliant les plots 36 à des plots 90 du premier niveau de métallisation de l'empilement 85.

Selon un mode de réalisation, le circuit global d'affichage 32 comprend de bas en haut en figure 14 :
- un support 91 formant la face inférieure 38 du circuit global d'affichage 32 au contact de la face supérieure 35 du circuit global de commande 30 et comprenant des plots conducteurs 92 exposés sur la face inférieure 38, au contact des plots 90, et une structure isolante multicouches 93, par exemple en oxyde de silicium et en nitrure de silicium, s'étendant entre les plots 92 et recouvrant les plots 92 et comprenant des ouvertures 94 exposant des portions des plots 92 ;
- des microfils ou nanofils 95, appelés fils par la suite (six fils étant représentés), chaque fil 95 étant en contact avec l'un des plots 92 au travers de l'une des ouvertures 94 ;
- une couche isolante 96 s'étendant sur les flancs latéraux d'une portion inférieure de chaque fil 95 et s'étendant sur la couche isolante 93 entre les fils 95 ;
- une coque 98 comprenant un empilement de couches semiconductrices recouvrant une portion supérieure de chaque fil 95 et s'étendant sur la couche isolante 96 entre les fils 95, la coque 98 comprenant notamment une couche active qui est la couche depuis laquelle est émise la majorité du rayonnement fourni par la diode électroluminescente et comportant par exemple des moyens de confinement, tels que des puits quantiques multiples ;
- une couche conductrice 100 et réfléchissante, s'étendant sur la coque 98 entre les fils 95 ;
- une couche conductrice 102 transparente formant une électrode recouvrant, pour chaque fil 95, la coque 98 et s'étendant, en outre, sur la couche conductrice 100 entre les fils 95 ;
- des blocs photoluminescents 104 recouvrant certains ensembles de diodes électroluminescentes LED ou des blocs transparents au rayonnement émis par les diodes électroluminescentes, chaque bloc photoluminescent comprenant des luminophores adaptés, lorsqu'ils sont excités par la lumière émis par les diodes électroluminescentes LED associées, à émettre de la lumière à une longueur d'onde différente de la longueur d'onde de la lumière émise par les diodes électroluminescentes LED associées ;
- une couche isolante 106 recouvrant la face supérieure de chaque bloc 104, la couche isolante 106 pouvant ne pas être présente ;
- une couche de protection 108 recouvrant les couches isolantes 106, les faces latérales des blocs 104 et la couche d'électrode 102 entre les blocs 104 ;
- des murs 110 entre les blocs 104, chaque mur 110 pouvant comprendre un coeur 112 entouré d'un revêtement 114 réfléchissant à la longueur d'onde du rayonnement émis par les blocs photoluminescents 104 et/ou les diodes électroluminescentes LED ;
- un filtre coloré 116 recouvrant au moins certains des blocs photoluminescents 104 ; et
- une couche d'encapsulation 118 recouvrant l'ensemble de la structure.

Les éléments de séparation 55 décrits précédemment ne sont pas représentés en figure 4 et peuvent entourer l'ensemble des sous-pixels d'affichage.

Chaque fil 95 peut avoir une structure semiconductrice allongée. Chaque fil 95 peut avoir une forme générale cylindrique avec une section droite pouvant avoir différentes formes, telles que, par exemple, une forme ovale, circulaire ou polygonale, notamment triangulaire, rectangulaire, carrée ou hexagonale. Chaque fil 95 a par exemple un diamètre moyen, correspondant par exemple au diamètre du disque ayant la même aire que la section droite du fil 95, compris entre 5 nm et 5 µm, de préférence entre 100 nm et 2 µm, plus préférentiellement entre 200 nm et 1,5 µm et une hauteur supérieure ou égale supérieure à 1 fois, de préférence supérieure ou égale à 3 fois et encore plus préférentiellement supérieure ou égale à 5 fois le diamètre moyen, notamment supérieure à 500 nm, de préférence comprise entre 1 µm et 50 µm. Les fils 95 comprennent au moins un matériau semiconducteur. Le matériau semiconducteur peut être du silicium, du germanium, du carbure de silicium, un composé III-V, par exemple du GaN, AlN, InN, InGaN, AlGaN ou AlInGaN, un composé II-VI ou une combinaison d'au moins deux de ces composés.

La couche conductrice 102 est adaptée à polariser les couches actives des coques 98 et à laisser passer le rayonnement électromagnétique émis par les diodes électroluminescentes. Le matériau formant la couche conductrice 102 peut être un matériau transparent et conducteur tel que du graphène, ou de l'argent, ou un oxyde transparent et conducteur (ou TCO, sigle anglais pour Transparent Conducting Oxide), notamment l'oxyde d'indium-étain (ou ITO, sigle anglais pour Indium Tin Oxide), de l'oxyde de zinc dopé ou non à l'aluminium, ou au gallium ou au bore. A titre d'exemple, la couche conductrice 102 a une épaisseur comprise entre 20 nm et 500 nm, de préférence entre 20 nm et 100 nm.

La couche conductrice 100, les pistes conductrices 86 et les plots conducteurs 36, 88, 92 peuvent être en métal, par exemple en aluminium, en argent, en platine, en nickel, en cuivre, en or ou en ruthénium ou en un alliage comprenant au moins deux de ces composés, notamment l'alliage PdAgNiAu ou l'alliage PtAgNiAu.

Chacune des couches isolantes 85, 93, 96, 106, 108, 118 est en un matériau choisi dans le groupe comprenant l'oxyde de silicium (SiO₂), le nitrure de silicium (SiₓN_{y}, où x est environ égal à 3 et y est environ égal à 4, par exemple du Si₃N₄), l'oxynitrure de silicium (notamment de formule générale SiOₓN_{y}, par exemple du Si₂ON₂), l'oxyde d'hafnium (HfO₂), l'oxyde de titane (TiO₂), ou l'oxyde d'aluminium (Al₂O₃).

Selon un mode de réalisation, toutes les diodes électroluminescentes d'un pixel d'affichage Pix émettent un rayonnement lumineux à la même longueur d'onde. La structure diffusante 52 recouvrant ce pixel d'affichage Pix peut alors contenir des luminophores adaptés, lorsqu'ils sont excités par la lumière émis par le pixel d'affichage, à émettre de la lumière à la couleur souhaitée. Ceci permet de réaliser la conversion de la longueur d'onde du rayonnement au niveau de la structure diffusante 52 et non au niveau du pixel d'affichage. De ce fait, par rapport à la structure du pixel d'affichage décrite précédemment en relation avec la figure 14, les blocs photoluminescents 104 et les filtres colorés 116 peuvent ne pas être présents. En outre, la densité de puissance reçue par les luminophores présents dans les structures diffusantes 52 est inférieure à la densité de puissance reçue par les luminophores lorsqu'ils sont intégrés directement dans les pixels d'affichage. Ceci est avantageux notamment lorsque les luminophores comprennent des boîtes quantiques dont les propriétés de conversion peuvent se dégrader dans le temps d'autant plus vite que la densité de puissance reçue par ces boîtes quantiques est élevée.

Les figures 15 à 26 sont des vues en coupe, partielles et schématiques, de structures obtenues à des étapes successives d'un mode de réalisation de l'écran d'affichage 60 représenté en figure 7.

La figure 15 représente la structure obtenue après une étape de formation d'une plaque optoélectronique 120 et une étape de formation d'une plaque logique 122. La plaque optoélectronique 120 comprend un support 124 ayant une face supérieure 126 et une face inférieure 128 et des diodes électroluminescentes LED formées sur la face supérieure 126. La plaque optoélectronique 120 comprend des diodes électroluminescentes LED des circuits globaux d'affichage de plusieurs groupe de pixels. La plaque logique 122 comprend les circuits globaux logiques de commande de plusieurs groupes de pixels.

La figure 16 représente la structure obtenue après une étape de fixation de la plaque optoélectronique 120 sur la plaque logique 122 du côté des diodes électroluminescentes LED et le retrait du support 124 de la plaque optoélectronique 120. L'empilement 130 de la plaque logique 122 et de la plaque optoélectronique 122 diminuée du support 124 est appelée plaque de pixels d'affichage par la suite.

La figure 17 représente la structure obtenue après une étape de formation d'une structure optique 132 sur la plaque optoélectronique 120 et la formation des deuxièmes éléments de séparation 55 dans la structure optique 132 et les diodes électroluminescentes LED. La structure optique 132 peut avoir une structure monocouche ou une structure multicouche. Les deuxièmes éléments de séparation 55 peuvent comprendre des murs opaques et/ou réfléchissants. La structure optique 132 peut comprendre les blocs photoluminescents et les filtres de couleur décrits précédemment. A titre de variante, la structure optique 132 peut ne pas être présente.

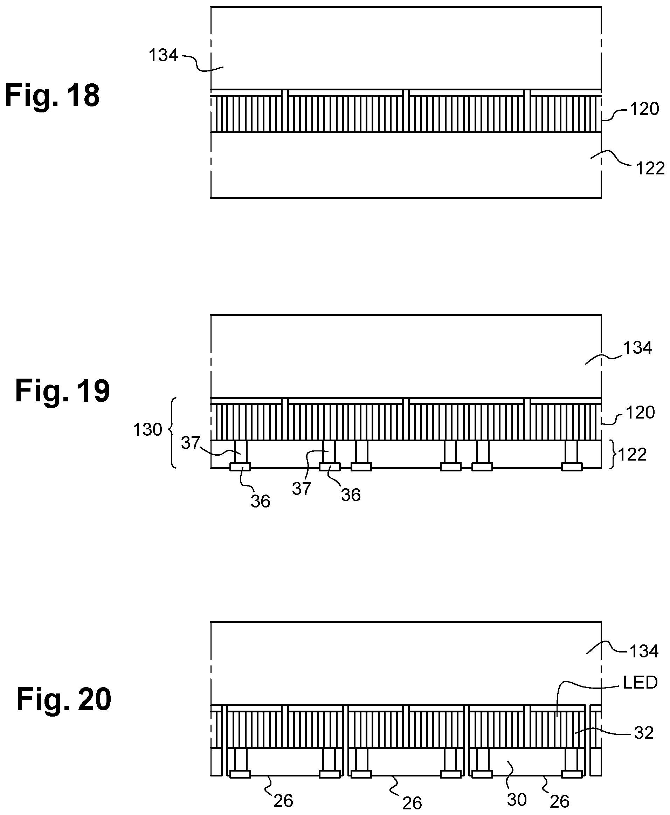

La figure 18 représente la structure obtenue après une étape de fixation de la plaque de pixels d'affichage 130 à une poignée 134 du côté de la plaque optoélectronique 120.

La figure 19 représente la structure obtenue après une étape d'amincissement de la plaque logique 122, une étape de formation de TSV 37 au travers de la plaque logique 122 amincie, et la formation de plots conducteurs 36, du côté de la face inférieure de la plaque de pixels d'affichage 130, connectés électriquement aux TSV 37.

La figure 20 représente la structure obtenue après une étape de découpe de la plaque de pixels d'affichage 130 pour séparer les groupes de pixels 26. Cette étape peut être réalisée par sciage. Chaque groupe de pixels 26 ainsi délimité comprend un circuit global d'affichage 32 comprenant les diodes électroluminescentes LED d'au moins deux pixels d'affichage, de préférence de quatre pixels d'affichage, et un circuit global 30 de commande des diodes électroluminescentes des pixels d'affichage du groupe de pixels 26.

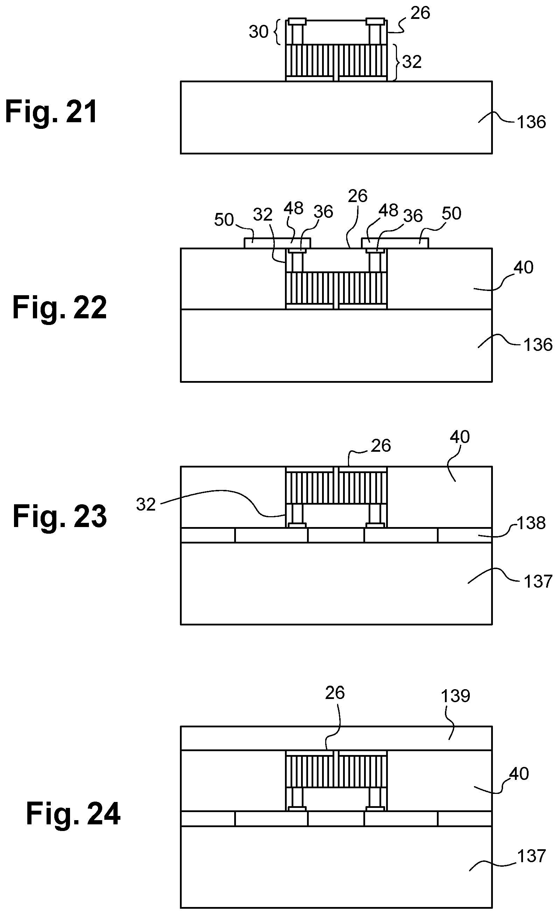

La figure 21 représente la structure obtenue après une étape de transfert d'au moins un groupe de pixels 26 de la poignée 134 vers une poignée 136, le groupe de pixels 26 étant fixé à la poignée 136 du côté du circuit global d'affichage 32. Selon un mode de réalisation, cette étape de transfert peut comprendre un premier transfert du groupe de pixels 26 de la poignée 134 vers une poignée intermédiaire, non représentée, le groupe de pixels 26 étant fixé à la poignée intermédiaire du côté du circuit global de commande 30 et le transfert du groupe de pixels 26 de la poignée intermédiaire vers la poignée 136.

La figure 22 représente la structure obtenue après une étape de formation d'une couche diélectrique sur la poignée 136 et sur le bloc de pixels d'affichage, une étape de planarisation pour exposer le circuit global de commande 30 du groupe de pixels 26 et délimiter ainsi la gaine 40 entourant le groupe de pixels 26, et une étape de formation des pistes 48 et des plots de contact 50, les piste 48 s'étendant sur le circuit global de commande 30 du groupe de pixels 26 et sur la gaine 40, les plots de contact 50 reposant sur la gaine 40. L'étape de planarisation peut comprendre une étape de CMP. Le bloc de pixels 28 est alors partiellement formé. Pour chaque bloc de pixels 28, le groupe de pixels 26 du bloc de pixels 28 comprend les diodes électroluminescentes associées à plusieurs pixels d'affichage qui sont commandés par le même circuit de global de commande 30. Ceci permet de façon avantageuse de réduire le nombre de plots conducteurs 36 nécessaire pour l'alimentation/la commande de ces pixels d'affichage. Le nombre réduit de plots conducteurs 36 par pixels d'affichage, et la formation des plots de contact 50 permet d'augmenter l'écart entre les plots de contact 50. Ceci facilite la pose ultérieure, décrite par la suite, des blocs de pixels 28 sur une dalle, en diminuant les contraintes quant à la précision du positionnement des blocs de pixels 28 au moment du transfert sur la dalle.

La figure 23 représente la structure obtenue après une étape de transfert du bloc de pixels 28 partiellement formé de la poignée 136 vers une autre poignée 137 du côté du circuit global de commande 30 du groupe de pixels 26, par exemple par l'intermédiaire d'une couche de colle 138.

La figure 24 représente la structure obtenue après une étape de formation d'une couche diffusante 139 sur la gaine 40 et le groupe de pixels 26. Selon un mode de réalisation, la formation de la couche diffusante 139 comprend la formation sur la face émissive du bloc de pixels d'affichage d'une couche d'un matériau diffusant. Selon un mode de réalisation, la formation de la couche diffusante comprend la formation sur la face émissive du bloc de pixels d'affichage d'une couche d'un matériau transparent et la formation d'une texturation sur la surface de la couche.

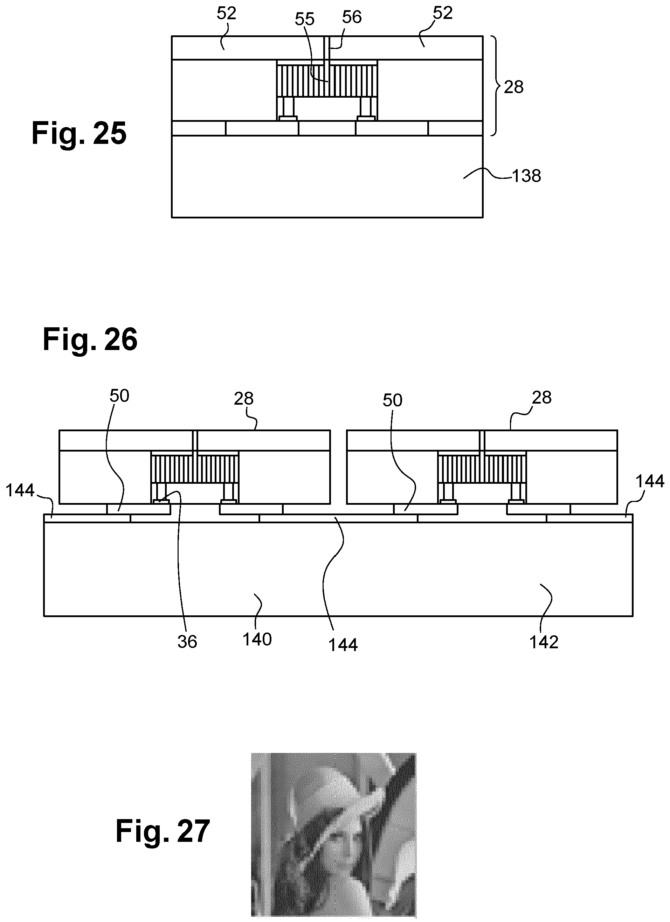

La figure 25 représente la structure obtenue après la formation des deuxièmes éléments de séparation 56 dans la couche diffusante 139 pour obtenir les structures diffusantes 52. Les deuxièmes éléments de séparation 56 sont formés de façon alignée avec les premiers éléments de séparation 55 du groupe de pixels 26, et, lorsqu'ils sont présents, avec les troisièmes éléments de séparation présents dans la gaine 40. Selon un mode de réalisation, la formation des premiers éléments de séparation 56 comprend la formation de tranchées dans la structure diffusante 52. Selon un autre mode de réalisation, la formation des deuxièmes éléments de séparation 56 comprend la formation, dans la structure diffusante 52, de murs réfléchissants sur la totalité de l'épaisseur la structure diffusante 52. L'alignement des deuxièmes éléments de séparation 56 avec les premiers éléments de séparation 55 est, de façon avantageuse, plus facile et précis à réaliser par la formation des deuxièmes éléments de séparation 56 dans la structure diffusante 52 reposant sur le groupe de pixels 26 et la gaine 40 par rapport au cas où il serait obtenu en déposant le groupe de pixel 26, contenant les premiers éléments de séparation 55, sur la structure diffusante 52 contenant les deuxièmes éléments de séparation 56. Le bloc de pixels 28 est alors obtenu.

La figure 26 représente la structure obtenue après une étape de transfert de blocs de pixels 28 sur une dalle 140 d'écran d'affichage. La dalle 140 peut comprendre un support 142 sur lequel s'étendent des pistes conductrices 144. Chaque plot de contact 50 de chaque bloc de pixels 28 est au contact de l'une des pistes conductrices 144. Le transfert peut être effectué par blocs de pixels 28 individuels ou par groupes de blocs de pixels 28. L'agrandissement et l'écartement respectif des plots de contact 50 par rapport aux plots conducteurs 36 permet, de façon avantageuse, de diminuer les contraintes de précision et permet un positionnement plus rapide et moins onéreux des blocs de pixels 28 sur la dalle 140.

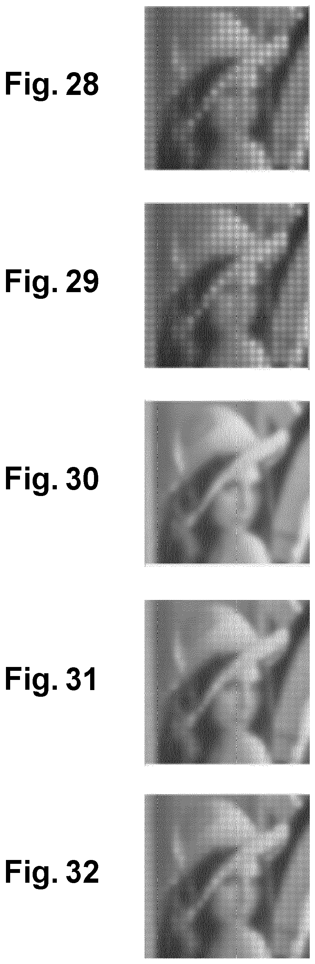

Des essais ont été réalisés comprenant l'affichage de l'image de la figure 27 sur différents écrans d'affichage. Pour ces essais, les groupes de pixels comprennent chacun quatre pixels d'affichage. Les figures 28, 29, 30, 31, et 32 ont été obtenues par simulations.

Les figures 28 et 29 représentent chacune l'image telle qu'elle apparaît à un observateur lorsque l'écran d'affichage a la structure représentée en figure 2, la surface occupée par les groupes de pixels en vue de dessus correspondant à 1 % de la surface de l'écran d'affichage en figure 28 et à 1 % de la surface de l'écran d'affichage en figure 29. Les pixels d'image des quatre pixels d'affichage d'un même groupe sont difficilement distinguables par un observateur.

Les figures 30, 31, et 32 représentent chacune l'image telle qu'elle apparaît à un observateur lorsque l'écran d'affichage a la structure représentée en figure 7, la surface occupée par les blocs de pixels en vue de dessus correspondant à 100 % de la surface de l'écran d'affichage en figure 30, à 80 % de la surface de l'écran d'affichage en figure 31, et à 64 % de la surface de l'écran d'affichage en figure 32. Les pixels d'image des quatre pixels d'affichage d'un même groupe sont distinguables par un observateur.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la structure diffusante peut comprendre une partie formant un guide d'ondes tel que représenté sur les figures 10 à 13 et une partie en un matériau diffusant. En outre bien que dans les modes de réalisation décrits précédemment le groupe de pixels 26 comprenne deux puces fixées l'une à l'autre, il est clair que le groupe de pixels peut comprendre une puce unique, le circuit global de commande des diodes électroluminescents étant réalisé de façon intégrée avec les diodes électroluminescentes ou n'étant pas intégré au groupe de pixels. Enfin, la mise en oeuvre pratique des modes de réalisation et variantes décrits est à la portée de la personne du métier à partir des indications fonctionnelles données ci-dessus. La portée de l'invention est définie par les revendications.

## Revendications

1. Bloc d'affichage (28) comprenant :
- un circuit optoélectronique (26) comprenant des diodes électroluminescentes (LED) d'au moins deux pixels d'affichage (Pix) et ayant une première face d'émission (39) des rayonnements lumineux des diodes électroluminescentes ; et **caractérisé en ce qu'**il comprend :
- des structures diffusantes (52) recouvrant le circuit optoélectronique (26), chaque structure diffusante étant au contact d'une partie de la première face d'émission (39) et ayant une deuxième face d'émission (54) des rayonnements lumineux des diodes électroluminescentes de l'un des pixels d'affichage, le rapport entre la somme des aires des deuxièmes faces d'émission (54) et l'aire de la première face d'émission (39) étant supérieure à 2.

2. Bloc d'affichage selon la revendication 1, dans lequel les pixels d'affichage (Pix) sont séparés par des premiers éléments de séparation ne laissant pas passer les rayonnements lumineux des diodes électroluminescentes (LED) et dans lequel les structures diffusantes (52) sont séparées par des deuxièmes éléments de séparation (56) ne laissant pas passer les rayonnements lumineux des diodes électroluminescentes (LED), les premiers éléments de séparation (55) étant alignés avec les deuxièmes éléments de séparation (56) au niveau de la première face d'émission (39).

3. Bloc d'affichage selon la revendication 1 ou 2, dans lequel chaque deuxième face d'émission (54) est une surface diffusante.

4. Bloc d'affichage selon la revendication 1 ou 2, dans lequel chaque structure diffusante (52) est au moins en partie composée d'un matériau diffusant ou au moins en partie composée d'un guide d'ondes.

5. Bloc d'affichage selon la revendication 1 ou 2, dans lequel chaque structure diffusante (52) comprend des motifs (70) répartis sur une surface et réfléchissant ou diffusant les rayonnements lumineux.

6. Bloc d'affichage selon l'une quelconque des revendications 1 à 5, comprenant une gaine isolante électriquement (40) entourant le circuit optoélectronique (26), les structures diffusantes (52) recouvrant la gaine, au contact de la gaine ou séparée de la gaine par un film d'air par l'intermédiaire d'espaceurs interposés entre la gaine et les structures diffusantes.

7. Bloc d'affichage selon la revendication 6, dans lequel le circuit optoélectronique (26) comprend une troisième face (34) opposée à la première face (39) et des premiers plots conducteurs électriquement (36) exposés sur la troisième face, le bloc d'affichage (28) comprenant des pistes conductrices électriquement (48) au contact des premiers plots conducteurs électriquement (36) et se prolongeant par des deuxièmes plots conducteurs électriquement (50) s'étendant sur la gaine (40).

8. Bloc d'affichage selon l'une quelconque des revendications 1 à 5, dans lequel chaque structure diffusante (58) reçoit seulement le rayonnement lumineux des diodes électroluminescentes (LED) de l'un des pixels d'affichage.

9. Bloc d'affichage selon l'une quelconque des revendications 1 à 8, dans lequel au moins l'une des structures diffusantes (52) contient des luminophores.

10. Bloc d'affichage selon l'une quelconque des revendications 1 à 9, dans lequel les pixels d'affichage (Pix) du circuit optoélectronique (26) sont jointifs et dans lequel la première face d'émission (39) est centrée par rapport à la surface formée par les deuxièmes faces d'émission (54).

11. Bloc d'affichage selon l'une quelconque des revendications 1 à 10, dans lequel le circuit optoélectronique (26) comprend quatre pixels d'affichage (Pix).

12. Bloc d'affichage selon l'une quelconque des revendications 1 à 11, dans lequel le circuit optoélectronique (26) comprend un seul circuit de commande (30) de toutes les diodes électroluminescentes (LED) des pixels d'affichage (Pix).

13. Ecran d'affichage (60) comprenant une dalle (140) et une pluralité de blocs d'affichage (28) selon l'une quelconque des revendications 1 à 12 fixés à la dalle.

14. Ecran d'affichage selon la revendication 13, dans lequel les pixels d'affichage (Pix) des blocs d'affichage (28) sont agencés en rangées et en colonnes, et dans lequel le circuit optoélectronique (26) de chaque bloc d'affichage (28) comprend au moins quatre pixels d'affichage (Pix) appartenant à au moins deux rangées adjacentes et à au moins deux colonnes adjacentes.

15. Procédé de fabrication de blocs d'affichage (28) selon l'une quelconque des revendications 1 à 12, comprenant les étapes suivantes :
a) formation d'une plaque (130) comprenant une pluralité desdits circuits optoélectroniques (26) ;
b) découpage de la plaque pour séparer lesdits circuits optoélectroniques ; et
c) pour chaque circuit optoélectronique séparé, formation des structures diffusantes (52) recouvrant le circuit optoélectronique (26).

16. Procédé selon la revendication 14, comprenant, en outre, à l'étape a), la formation de premiers éléments de séparation (55) dans chaque circuit optoélectronique (26) séparant les pixels d'affichage (Pix), et, à l'étape c), la formation de deuxièmes éléments de séparation (56) séparant les structures diffusantes et alignés avec les premiers éléments de séparation.

## Patentansprüche

1. Anzeigeblock (28), der Folgendes aufweist:
- eine optoelektronische Schaltung (26) aufweisend Leuchtdioden (LED) von wenigstens zwei Anzeigepixeln (Pix) und mit einer ersten Emissionsoberfläche (39) der Lichtstrahlungen der Leuchtdioden; und **dadurch gekennzeichnet, dass** sie Folgendes aufweist:
- Diffusionsstrukturen (52), die die optoelektronische Schaltung (26) abdecken, wobei jede Diffusionsstruktur mit einem Teil der ersten Emissionsoberfläche (39) in Kontakt steht und eine zweite Emissionsoberfläche (54) der Lichtstrahlungen der Leuchtdioden eines der Anzeige-Pixel aufweist, wobei das Verhältnis der Summe der Flächen der zweiten Emissionsoberflächen (54) zur Fläche der ersten Emissionsoberfläche (39) größer als 2 ist.

2. Anzeigeblock nach Anspruch 1, wobei die Anzeigepixel (Pix) durch erste Trennelemente getrennt sind, die die Lichtstrahlungen der Leuchtdioden (LED) nicht durchlassen, und wobei die Diffusionsstrukturen (52) durch zweite Trennelemente (56) getrennt sind, die die Lichtstrahlungen der Leuchtdioden (LED) nicht durchlassen, wobei die ersten Trennelemente (55) mit den zweiten Trennelementen (56) auf Höhe der ersten Emissionsoberfläche (39) aufeinander ausgerichtet sind.

3. Anzeigeblock nach Anspruch 1 oder 2, wobei jede zweite Emissionsoberfläche (54) eine Diffusionsfläche ist.

4. Anzeigeblock nach Anspruch 1 oder 2, wobei jede Diffusionsstruktur (52) wenigstens teilweise aus einem Diffusionsmaterial besteht oder wenigstens teilweise aus einem Wellenleiter gebildet ist.

5. Anzeigeblock nach Anspruch 1 oder 2, wobei jede Diffusionsstruktur (52) Muster (70) aufweist, die auf einer Oberfläche verteilt sind und die Lichtstrahlungen reflektieren oder streuen.

6. Anzeigeblock nach einem der Ansprüche 1 bis 5 aufweisend eine elektrisch isolierende Hülle (40), die die optoelektronische Schaltung (26) umhüllt, wobei die Diffusionsstrukturen (52) die Hülle bedecken, mit der Hülle in Kontakt stehen oder von der Hülle durch einen Luftfilm über Abstandshalter getrennt sind, die zwischen der Hülle und den Diffusionsstrukturen angeordnet sind.

7. Anzeigeblock nach Anspruch 6, wobei die optoelektronische Schaltung (26) eine dritte Oberfläche (34) gegenüber der ersten Oberfläche (39) und erste elektrisch leitende Pads (36) aufweist, die auf der dritten Oberfläche freiliegen, wobei der Anzeigeblock (28) elektrisch leitende Bahnen (48) aufweist, die mit den ersten elektrisch leitenden Pads (36) in Kontakt stehen und durch zweite elektrisch leitende Pads (50) fortgesetzt werden, die sich auf der Hülle (40) erstrecken.

8. Anzeigeblock nach einem der Ansprüche 1 bis 5, wobei jede Diffusionsstruktur (58) nur die Lichtstrahlung der Leuchtdioden (LED) eines der Anzeigepixel empfängt.

9. Anzeigeblock nach einem der Ansprüche 1 bis 8, wobei wenigstens eine der Diffusionsstrukturen (52) Luminophore enthält.

10. Anzeigeblock nach einem der Ansprüche 1 bis 9, wobei die Anzeigepixel (Pix) der optoelektronischen Schaltung (26) zusammenhängend sind und wobei die erste Emissionsoberfläche (39) zentriert ist in Bezug auf die Oberfläche, die durch die zweiten Emissionsoberflächen (54) gebildet wird.

11. Anzeigeblock nach einem der Ansprüche 1 bis 10, wobei die optoelektronische Schaltung (26) vier Anzeigepixel (Pix) aufweist.

12. Anzeigeblock nach einem der Ansprüche 1 bis 11, wobei die optoelektronische Schaltung (26) eine einzige Schaltung zum Steuern (30) aller Leuchtdioden (LED) der Anzeigepixel (Pix) aufweist.

13. Anzeigeschirm (60), der eine Platte (140) und eine Vielzahl von Anzeigeblöcken (28) nach einem der Ansprüche 1 bis 12 aufweist, die mit der Platte verbunden sind.

14. Anzeigeschirm nach Anspruch 13, wobei die Anzeigepixel (Pix) der Anzeigeblöcke (28) in Zeilen und Spalten angeordnet sind und wobei die optoelektronische Schaltung (26) jedes Anzeigeblocks wenigstens vier Anzeigepixel (Pix) aufweist, die zu wenigstens zwei benachbarten Zeilen und zu wenigstens zwei benachbarten Spalten gehören.

15. Verfahren zur Herstellung von Anzeigeblöcken (28) nach einem der Ansprüche 1 bis 12, das die folgenden Schritte aufweist:
a) Ausbilden eines Wafers (130), der eine Vielzahl der optoelektronischen Schaltungen (26) aufweist;
b) Schneiden des Wafers, um die optoelektronischen Schaltungen zu trennen; und
c) für jede getrennte optoelektronische Schaltung, Ausbilden der Diffusionsstrukturen (52), die die optoelektronische Schaltung (26) bedecken.

16. Verfahren nach Anspruch 14, ferner aufweisend in Schritt a) das Ausbilden von ersten Trennelementen (55) in jeder optoelektronischen Schaltung (26), die die Anzeigepixel (Pix) trennen, und in Schritt c) das Ausbilden von zweiten Trennelementen (56), die die Diffusionsstrukturen trennen und mit den ersten Trennelementen ausgerichtet sind.

## Claims

1. Display block (28) comprising:
- an optoelectronic circuit (26) comprising light-emitting diodes (LED) of at least two display pixels (Pix) and having a first surface of emission (39) of the light radiations of the light-emitting diodes; and **characterized in that** it comprises:
- diffusing structures (52) covering the optoelectronic circuit (26), each diffusing structure being in contact with a portion of the first emission surface (39) and having a second surface of emission (54) of the light radiations of the light-emitting diodes of one of the display pixels, the ratio of the sum of the areas of the second emission surfaces (54) to the area of the first emission surface (39) being greater than 2.

2. Display block according to claim 1, wherein the display pixels (Pix) are separated by first separation elements which do not let through the light radiations of the light-emitting diodes (LED) and wherein the diffusing structures (52) are separated by second separation elements (56) which do not let through the light radiations of the light-emitting diodes (LED), the first separation elements (55) being aligned with the second separation elements (56) at the level of the first emission surface (39).

3. Display block according to claim 1 or 2, wherein each second emission surface (54) is a diffusing surface.

4. Display block according to claim 1 or 2, wherein each diffusing structure (52) is at least partly made of a diffusing material or at least partly formed of a waveguide.

5. Display block according to claim 1 or 2, wherein each diffusing structure (52) comprises patterns (70) distributed on a surface and reflecting or diffusing the light radiations.

6. Display block according to any of claims 1 to 5, comprising an electrically-insulating sheath (40) surrounding the optoelectronic circuit (26), the diffusing structures (52) covering the sheath, in contact with the sheath or separated from the sheath by an air film via spacers interposed between the sheath and the diffusing structures.

7. Display block according to claim 6, wherein the optoelectronic circuit (26) comprises a third surface (34) opposite to the first surface (39) and first electrically-conductive pads (36) exposed on the third surface, the display block (28) comprising electrically-conductive tracks (48) in contact with the first electrically-conductive pads (36) and continued by second electrically-conductive pads (50) extending on the sheath (40).

8. Display block according to any of claims 1 to 5, wherein each diffusing structure (58) only receives the light radiation of the light-emitting diodes (LED) of one of the display pixels.

9. Display block according to any of claims 1 to 8, wherein at least one of the diffusing structures (52) contains luminophores.

10. Display block according to any of claims 1 to 9, wherein the display pixels (Pix) of the optoelectronic circuit (26) are contiguous and wherein the first emission surface (39) is centered with respect to the surface formed by the second emission surfaces (54).

11. Display block according to any of claims 1 to 10, wherein the optoelectronic circuit (26) comprises four display pixels (Pix).

12. Display block according to any of claims 1 to 11, wherein the optoelectronic circuit (26) comprises a single circuit for controlling (30) all the light-emitting diodes (LED) of the display pixels (Pix).

13. Display screen (60) comprising a slab (140) and a plurality of display blocks (28) according to any of claims 1 to 12 bonded to the slab.

14. Display screen according to claim 13, wherein the display pixels (Pix) of the display blocks (28) are arranged in rows and in columns, and wherein the optoelectronic circuit (26) of each display block comprises at least four display pixels (Pix) belonging to at least two adjacent rows and to at least two adjacent columns.

15. Method of manufacturing display blocks (28) according to any of claims 1 to 12, comprising the following steps:
a) forming of a wafer (130) comprising a plurality of said optoelectronic circuits (26);
b) cutting of the wafer to separate said optoelectronic circuits; and
c) for each separate optoelectronic circuit, forming of the diffusing structures (52) covering the optoelectronic circuit (26).

16. Method according to claim 14, further comprising, at step a), the forming of first separation elements (55) in each optoelectronic circuit (26) separating the display pixels (Pix), and, at step c), the forming of second separation elements (56) separating the diffusing structures and aligned with the first separation elements.
